(19) Europäisches Patentamt / European Patent Office / Office européen des brevets

(11) **EP 3 875 182 A1**

(12) **EUROPEAN PATENT APPLICATION**
published in accordance with Art. 153(4) EPC

(43) Date of publication:
**08.09.2021 Bulletin 2021/36**

(51) Int Cl.:
**B21D 22/28** (2006.01)          **B21D 37/01** (2006.01)
**B21D 37/18** (2006.01)          **B21D 51/26** (2006.01)

(21) Application number: **19878663.4**

(22) Date of filing: **17.10.2019**

(86) International application number:
**PCT/JP2019/040934**

(87) International publication number:
**WO 2020/090504 (07.05.2020 Gazette 2020/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **31.10.2018   JP 2018204823**
                **31.10.2018   JP 2018204935**

(71) Applicant: **Toyo Seikan Group Holdings, Ltd.**
**Shinagawa-ku**
**Tokyo 141-8627 (JP)**

(72) Inventors:
• **SHIROISHI, Ryozo**
  **Yokohama City Kanagawa 240-0062 (JP)**
• **MATSUMOTO, Naoya**
  **Yokohama City Kanagawa 240-0062 (JP)**
• **SHIMAMURA, Masahiro**
  **Yokohama City Kanagawa 240-0062 (JP)**
• **KUMAGAI, Takuho**
  **Yokohama City Kanagawa 240-0062 (JP)**
• **OGAWA, Tomohiro**
  **Yokohama City Kanagawa 240-0062 (JP)**

(74) Representative: **Dehns**
**St. Bride's House**
**10 Salisbury Square**
**London EC4Y 8JD (GB)**

(54) **MACHINING JIG, MACHINING METHOD, AND METHOD FOR MANUFACTURING SEAMLESS CAN BODIES**

(57)    Provided is a machining jig on which a carbon film (3) is formed on a machining surface of a rigid substrate (1), in which the carbon film (3) indicates a Raman spectroscopy spectrum with an intensity ratio, represented by the formula: $I_D/I_G$ (where $I_D$ is the maximum peak intensity at $1333 \pm 10$ cm$^{-1}$ in the Raman spectroscopy spectrum of the carbon film surface, and $I_G$ is the maximum peak intensity at $1500 \pm 100$ cm$^{-1}$ in the Raman spectroscopy spectrum of the carbon film surface), exceeding 0.6. Also provided is a method of manufacturing seamless can bodies, the method including a step of using a mold machining member, on which a diamond film is formed on a machining surface, to press work a metal material onto the machining surface of the mold machining member in a state where a coolant is interposed.

[FIG. 1]

**Description**

[Technical Field]

The present invention relates to a machining jig formed with a carbon film on a machining surface and a machining method using the machining jig. In addition, the present invention relates to a method of manufacturing seamless can bodies, more specifically to a method of manufacturing seamless can bodies which is mediated by a coolant and is suitable for forming, for example, an aluminum can.

[Background Art]

A carbon film containing a diamond component which is a crystal of carbon is extremely high in hardness as well known, and excellent in abrasion resistance. Therefore, it has conventionally been practiced to form a carbon film on cutting tools such as a cutting tool, an end mill and a file, plastic working molds such as a punch and a die, and sliding members such as a valve lifter and a bearing, to thereby enhance machining properties and mechanical life.

Such carbon films include a diamond film containing much diamond component and a DLC film (diamond-like carbon film) containing much graphite component, and, particularly, in regard of carbon films to be applied to cutting tools and plastic working molds, various kinds of research have been conducted as to the compositions and characteristics thereof.

For example, PTL 1 proposes a metal machining jig formed with a hard carbon film including diamond and amorphous carbon, having a surface roughness Rmax of equal to or less than 2 $\mu$m, and indicating a Raman spectroscopy spectrum with an intensity ratio $I_G/I_D$, where the $I_D$ is the maximum peak intensity present at 1333 $\pm$ 10 cm$^{-1}$ in the Raman spectroscopy spectrum, and $I_G$ is the maximum peak intensity present at 1500 $\pm$ 100 cm$^{-1}$, of 0.2 to 20 ($I_D/I_G$ = 0.05 to 5), on a sliding surface with the metal to be machined. The metal machining jig is, specifically, a die or a punch for use in drawing, or a drawing die for use in wire drawing.

In addition, PTL 2 proposes a cutting tool diamond coating formed on a substrate, the coating being formed from a plurality of coating layers, and mechanical characteristics of the coating layers are controlled by the intensity ratio ($I_D/I_G$ or $I_G/I_D$) in the Raman spectroscopy spectrum analysis.

The peak in the region around 1333 cm$^{-1}$ in the Raman spectroscopy spectrum analysis is derived from the diamond component, while the peak in the region around the 1500 cm$^{-1}$ is derived from the graphite component. Therefore, as the intensity ratio ($I_D/I_G$) is higher, more diamond component is contained and the graphite component content is lower, which indicates that the carbon film is a high-purity diamond and, hence, high in hardness.

In PTL 1 and PTL 2, the intensity ratio ($I_G/I_D$ or $I_D/I_G$) in the Raman spectroscopy analysis is set in a predetermined range, for enhancing abrasion resistance and prolonging film life.

Incidentally, plastic working of a metal is generally conducted by press working, typical techniques of which are drawing and ironing. Conventionally, press working has been used as a method for manufacturing industrial products at low cost and in large volume. Such press working is suitable for machining a variety of workpieces, and examples of the workpieces include metallic materials such as steel, copper, and aluminum, and titanium, magnesium and the like.

As an example of the aforementioned industrial products, there can be mentioned, for example, can materials. For example, metallic cans such as aluminum cans and 2-piece cans (what is called seamless can bodies) are manufactured through the steps of stamping a flat plate shaped metallic plate into a disk shape of a predetermined size, drawing the disk-shaped plate to form a can with a small height, then ironing the can to thin the can, to form a metallic can substrate with a large height. The press working mold for press working for manufacturing seamless can bodies includes a punch section and a die section, and, in a state in which the punch section and the die section are spaced from each other by an appropriate clearance, the workpiece is press worked.

In the press working as above, particularly in ironing, by forming a carbon film on a mold, molding on a non-lubrication basis may be performed. For example, PTL 3 discloses a mold capable of ironing aluminum without using a lubricant, and discloses that a diamond-like carbon film of a film thickness of 0.5 to 5 $\mu$m is provided on the mold surface.

In addition, since the punch section and the die section are placed under a severe environment in press working, it is proposed, for example, in PTL 5 to PTL 8, to coat the machining surface of the mold with a carbon film such as a diamond film and a DLC film to enhance durability of the mold.

[Citation List]

[Patent Literature]

[PTL 1] Japanese Patent Laid-Open No. Hei 5-169162
[PTL 2] Japanese Patent Laid-Open No. Hei 6-297207
[PTL 3] Japanese Patent Laid-Open No. Hei 8-90092
[PTL 4] Japanese Patent No. 6012804
[PTL 5] Japanese Patent Laid-Open No. Hei 10-137861
[PTL 6] Japanese Patent Laid-Open No. Hei 11-277160
[PTL 7] Japanese Patent Laid-Open No. 2013-163187
[PTL 8] PCT Patent Publication No. WO 2017/033791

[Summary]

[Technical Problems]

However, ironing is a severe forming with large sliding of the jig used relative to the workpiece; particularly, the machining surface of the die is influenced by work hardening of the workpiece as the ironing ratio is enhanced, and a larger surface pressure is exerted as the ironing (thinning) progresses. Therefore, when a carbon film as conventionally known is provided, a critical forming is low, and the workpiece may not endure ironing with a high ironing ratio. For example, in ironing with an ironing ratio of equal to or more than 40%, the sliding resistance between the jig and the workpiece is enlarged, and thinning causes a tensile stress exceeding an allowable stress to be exerted on the workpiece, possibly resulting in defective forming.

Note that the ironing ratio is a plate thickness reduction rate, and is represented by the following formula, where $t0$ is the plate thickness before ironing, and $t1$ is the plate thickness after ironing; as the ironing ratio is high, the surface pressure exerted on the die is high, and severe forming is conducted.

$$\text{Ironing ratio (\%)} = 100 \times (t0 - t1)/t0$$

Incidentally, in PTL 8, an ironing die formed on a machining surface with a carbon film indicating an intensity ratio ($I_D/I_G$) in the Raman spectroscopy spectrum measurement of equal to or more than 1.0, particularly equal to or more than 1.2, is proposed by the present applicant. The ironing die is one formed with a carbon film high in diamond purity on the machining surface, is excellent in ironing property, and, even in severe ironing with an ironing ratio exceeding 40% in dry process, ensures that a formed product having a mirror surface or a smooth surface close to a mirror surface can be obtained, without causing defective forming.

The aforementioned carbon film surely indicates excellent machining property even in machining under severe conditions, but needs further improvement in that it is low in impact resistance.

Specifically, the machining jig is formed from a rigid substrate such as what is called hard metal, and the carbon film is formed on the machining surface of such a rigid substrate (a surface making contact with a workpiece such as a metal or alloy, at the time of machining) by vapor deposition or the like. When machining has been conducted using such a jig, film exfoliation has been generated with few machining cycles. Moreover, such film exfoliation constitutes a problem not only in dry process but also in machining under a liquid environment (machining in wet process using a lubricant).

Accordingly, it is an object of the present invention to provide a machining jig including a carbon film excellent in impact resistance on a machining surface, and a machining method using the machining jig.

In addition, it is another object of the present invention to provide a method of manufacturing a method of manufacturing seamless can bodies.

Specifically, since the press working mold is placed in a severe machining environment as aforementioned, it has been practiced, for example, to coat a machining surface of a die section or the like with various surface treatment films. As such a surface treatment film, it is desirable to coat the machining surface with a carbon film such as a diamond film and a DLC film that has high sliding characteristics and that is able to restrain agglutination of the workpiece at the time of pressing.

In the case where press working is conducted using a mold formed on a machining surface with a diamond film or the like having the above-mentioned high sliding characteristics, there is also a merit that what is called dry press working can be performed. The dry press working is press working conducted in a dry environment without using a lubricant at the time of press working. By dry press working, such steps as cleaning of the lubricant after can manufacture and waste water treatment after cleaning can be omitted, and cost and load on environment can be reduced, so that attention has been paid to dry press working.

However, in the dry press working, there have been points to be improved. Examples of the points to be improved that have been mentioned include the following (a) to (c).

(a) A powder of a workpiece (for example, aluminum powder) is generated at the time of dry pressing, the powder is bitten into the mold, possibly resulting in generation of scratches on the can bodies after forming.

(b) Since a high temperature (locally, at or above 300°C) is needed between the mold and the workpiece at the time of dry pressing, it has been difficult, in performing severe machining (strong machining) such as, for example, ironing, to enhance the degree of machining (for example, critical ironing ratio).

(c) For the reason similar to (a) and (b) above, it has been difficult to enhance what is called forming stability in which can manufacture can be performed stably for a long time without causing such troubles as agglutination or deposition of the workpiece on the mold and breakage of can barrels.

On the other hand, conventionally, in the case of manufacturing seamless can bodies by use of aluminum, for example, it has been general practice to conduct forming in a wet environment by using a lubricant, such as an oil component, and a coolant. In this case, after can manufacture, a cleaning step (washer step) of degreasing the lubricant or the like adhered to the can bodies by a cleaning agent or a chemical agent is indispensable.

However, since a large amount of water is needed in the cleaning step, in recent years when efficient use of finite water resources has been admired, reconsideration of the step has been needed.

Further, since the waste water discharged in the cleaning step contains various chemical substances, necessity to reduce labor and cost required for waste water treatment has been pointed out.

The present inventors, in consideration of the above-exemplified problems, repeated extensive and intensive investigations. As a result, they have found out that in the case of performing press working by use of a coolant in specified conditions, merits equal to or more than those of the dry press working can be obtained.

In other words, in the case where press working is conducted with an oil component in a coolant set to a specific content while using a mold formed on a machining surface with a diamond film or the like having high sliding characteristics, even when severe machining such as ironing is conducted, a degree of machining (for example, critical ironing ratio) comparable to or more than that of press worked products manufactured by use of a lubricant in a conventional amount can be obtained.

In addition, the present inventors have found out that the problems as to the cleaning step and the waste water treatment step can also be solved, and have arrived at the present invention.

[Solution to Problems]

In accordance with the present invention, there is provided a machining jig having a carbon film formed on a machining surface of a rigid substrate,

in which the carbon film indicates a Raman spectroscopy spectrum with an intensity ratio exceeding 0.6, as expressed by the following formula

$$I_D / I_G$$

where

$I_D$ is a maximum peak intensity at $1333 \pm 10$ cm$^{-1}$ in the Raman spectroscopy spectrum of a surface of the carbon film, and
$I_G$ is a maximum peak intensity at $1500 \pm 100$ cm$^{-1}$ in the Raman spectroscopy spectrum of the surface of the carbon film.

In the machining jig of the present invention, it is preferable that (1) the surface of the carbon film is a smooth surface having an arithmetic average roughness Ra of equal to or less than 0.12 $\mu$m, and (2) the carbon film indicates a Raman spectroscopy spectrum with the intensity ratio of equal to or less than 1.1.

In accordance with the present invention, also, there is provided a machining method including machining a workpiece in a liquid environment by use of the aforementioned machining jig.

In this method, it is preferable that

(1) the machining jig is an ironing die, and the machining is ironing.

In addition, in order to achieve the above objects, a method of manufacturing seamless can bodies (1) includes the step of press working a metallic material at a machining surface of a mold machining member in a state in which a coolant is interposed, by use of the mold machining member formed with a diamond film on the machining surface.

In the method of manufacturing seamless can bodies of (1) above, it is preferable that (2) the oil component contained in the coolant is equal to or less than 4 vol%.

In the method of manufacturing seamless can bodies of (1) or (2) above, it is preferable that (3) the mold machining member includes at least a die section.

In addition, in the method of manufacturing seamless can bodies described in any one of (1) to (3) above, it is preferable that (4) the press working includes ironing of the metallic material, and a can barrel section is formed by ironing the metallic material such that the ironing ratio in the ironing is equal to or more than 10%.

Besides, in the method of manufacturing seamless can bodies described in any one of (1) to (4) above, it is preferable that (5) the surface roughness Ra of the mold machining member used for the ironing is equal to or less than 0.12 $\mu$m.

In addition, in the method of manufacturing seamless can bodies described in any of (1) to (4) above, it is preferable that (6) the surface roughness Ra of the mold machining member used for the ironing is equal to or less than 0.08 $\mu$m.

[Advantageous Effects of Invention]

The carbon film provided on the machining surface of the machining jig of the present invention has an important characteristic in that the intensity ratio $I_D/I_G$ in the Raman spectroscopy spectrum measurement exceeds 0.6, preferably is equal to or less than 1.1, more preferably is less than 1.0, and further preferably is equal to or less than 0.9. Specifically, in the conventional known technology, as the intensity ratio $I_D/I_G$ of the carbon film is enhanced (as the diamond purity is enhanced), better machining property is exhibited, but, in the present inventors' investigations, a result has been obtained that for enhancing impact resistance, it is advantageous to conversely reduce the intensity ratio $I_D/I_G$ to obtain a lower diamond purity. For example, as depicted in Examples described later, when a hard metal-made ball of 1/2 inches in diameter was collided against the carbon film surface repeatedly with a load of 200 N (400 shots/min.), film exfoliation was observed between 100000 to 200000 shots for the carbon film with the intensity ratio $I_D/I_G$ in excess of 1.1, whereas film exfoliation was not observed even when the collision exceeded 400000 shots for the carbon film having the intensity ratio $I_D/I_G$ of particularly less than 1.0 (for example, 0.9) according to the present invention.

In this way, by providing a carbon film with a small intensity ratio $I_D/I_G$ according to the present invention, it is possible to enhance impact resistance and to effectively prevent film exfoliation of the carbon film.

Thus, the machining jig of the present invention has the carbon film formed on the surface thereof being excellent in impact resistance, film exfoliation is not generated even in the case where machining is repeated a large number of times, and machining can be performed stably; to permit the excellent impact resistance of the carbon film of the machining jig of the present invention to be displayed maximally, the machining should be conducted under a liquid environment.

In other words, the carbon film provided on the machining surface of the machining jig of the present invention has the intensity ratio $I_D/I_G$ in a small range, and diamond purity is low; therefore, in the case where severe machining without use of a lubricant, such as dry process, is conducted, the mold machined surface of the workpiece obtained may be rough or defective forming may be generated. However, in the case where the machining jig of the present invention is applied to machining under a liquid environment, namely, machining in a wet process using a coolant, a mold machined surface high in smoothness can be obtained.

According to the method of manufacturing seamless can bodies of the present invention, the method includes the step of press working such as ironing by use of the mold machining member (for example, a punch section or a die section) formed with a diamond film on a machining surface, and, therefore, a high machining durability of the mold can be realized.

In addition, since the press working such as ironing is conducted in a state of being mediated by a coolant, by an effect of washing away a power of the workpiece (metal powder) generated upon ironing, biting-in of the metal powder into the mold and scratching of the external appearance of the can after forming can be restrained from occurring.

[Brief Description of Drawings]

[FIG. 1] FIG. 1 is a schematic side sectional view depicting an essential part of a machining jig of the present invention.
[FIG. 2] FIG. 2 is a diagram depicting an example of a Raman spectroscopy spectrum of a carbon film surface.
[FIG. 3] FIG. 3 is a diagram depicting an example of a press forming process utilizing ironing.
[FIG. 4] FIG. 4 is a schematic partial side view of an annular ironing die to which the present invention is applied.
[FIG. 5] FIG. 5 is a schematic side sectional view of a test machine for measuring impact resistance of the carbon film formed on a machining surface of the machining jig.
[FIG. 6] FIG. 6(a) is a schematic diagram depicting a press working step in the method of manufacturing a seamless can body of the present invention, and FIG. 6(b) is a schematic diagram in Example 1.

[Description of Embodiment]

The present invention will be specifically described referring to the drawings as required. The following embodiment indicates an example of the present invention, describes the contents thereof, and does not intentionally limit the present invention.

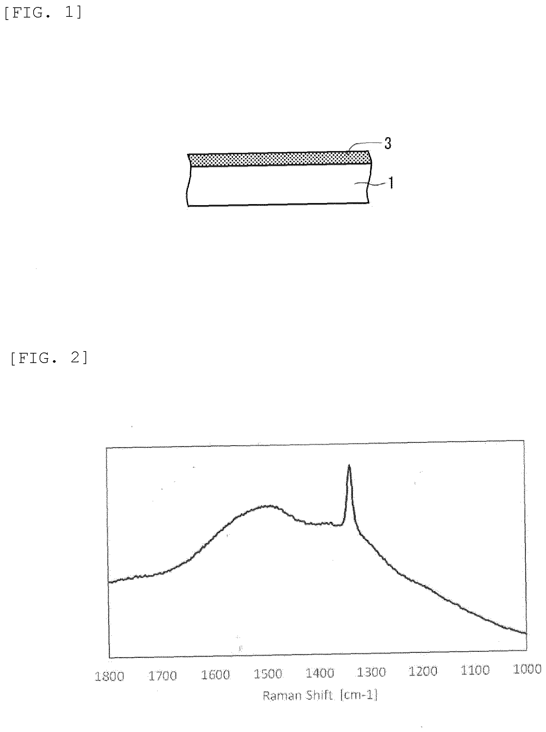

A machining jig of the present invention is used for machining of a hard material, for example, various metals and alloys, for example, severe machining such as drawing, ironing, drawing-ironing, and cutting, and, as illustrated in the schematic diagram of FIG. 1, it includes a rigid substrate 1 and a carbon film 3 provided on a surface of the rigid substrate 1.

The rigid substrate 1 is formed of a material which has such a rigidity as to endure severe machining and has such heat resistance as to endure high-temperature heating at the time of forming the carbon film 3. Typical examples of such a material having both rigidity and heat resistance include what is called hard metal obtained by sintering a mixture of tungsten carbide (WC) with a metallic binder such as cobalt, cermet obtained by sintering a mixture of a metallic carbide such as titanium carbide (TiC) or a titanium compound such as titanium carbonitride (TiCN) with a metallic binder such as cobalt, and hard ceramics such as silicon carbide (SiC), silicon nitride ($Si_3N_4$), alumina ($Al_2O_3$), and zirconia ($ZrO_2$).

The carbon film 3 has an intensity ratio represented by the following formula (1):

$$I_D/I_G \qquad (1)$$

where

$I_D$ is a maximum peak intensity at $1333 \pm 10$ cm$^{-1}$ in the Raman spectroscopy spectrum of the surface of the carbon film 3, and
$I_G$ is a maximum peak intensity at $1500 \pm 100$ cm$^{-1}$ in the Raman spectroscopy spectrum of the surface of the carbon film,
exceeding 0.6, preferably equal to or less than 1.1, more preferably less than 1.0, and further preferably equal to or less than 0.9.

Referring to FIG. 2 depicting the Raman spectroscopy spectrum of the carbon film formed in Experiment Examples described later, the maximum peak intensity $I_D$ at $1333 \pm 10$ cm$^{-1}$ is derived from a diamond component in the film, whereas the maximum peak intensity $I_G$ at $1500 \pm 100$ cm$^{-1}$ is derived from a graphite component in the film. Therefore, as the peak intensity ratio is smaller, the content of graphite is high, and, as the peak intensity ratio is larger, the film is closer to a diamond crystal. For example, a carbon film having the intensity ratio of equal to or less than 0.6 is not a diamond film but is a film of what is called DLC film. As understood from this, the carbon film 3 in the present invention has a large characteristic of containing a graphite component such as to satisfy the above-mentioned intensity ratio, and is different from the conventional carbon film for which the peak intensity ratio is set high and which is required to contain the diamond crystal at a level equal to or more than a certain value.

In the present invention, since the carbon film 3 satisfies the aforementioned intensity ratio and contains much graphite component, the particle diameter of diamond is small and the area of crystal boundaries is enlarged, so that excellent impact resistance is exhibited. For example, when subjected to an impact strength test, film exfoliation is effectively restrained, even in the case where the shot number exceeds 400000, and severe machining can be performed repeatedly. In other words, the carbon film 3 containing much graphite component is high in following-up property to the rigid substrate 1 as a ground, and, as a result, it is considered that a high impact resistance is exhibited and film exfoliation is effectively prevented.

In addition, in the present invention, the carbon film 3 preferably has a surface roughness Ra (JIS (Japanese Industrial Standard) B-0601-1994) of equal to or less than 0.12 $\mu$m, particularly equal to or less than 0.08 $\mu$m. Specifically, since the carbon film 3 contains a highly hard diamond crystal, the surface thereof tends to be rough. Therefore, it is preferable, after forming the film, to subject the film to polishing to make the smooth surface having the aforementioned roughness. Particularly, in the case of ironing by use of a jig including such a carbon film 3, a high surface pressure is exerted between the jig and the workpiece at the time of machining, and it is preferable that the surface roughness of the carbon film 3 is set in the aforementioned range, from the viewpoint of enhancing slidability between the jig and the workpiece at the time of ironing and from the viewpoint of finishing the surface of the workpiece into a smooth surface close to a mirror surface.

In the present invention, the aforementioned carbon film 3 is produced by forming a film on the surface of the rigid substrate 1 by a known method such as a heat filament CVD (Chemical Vapor Deposition) method, a plasma CVD method, for example, microwave plasma CVD, highfrequency plasma CVD, or heat plasma CVD, followed by surface polishing.

Note that, in forming the film, generally, a gas obtained by diluting a hydrocarbon gas such as methane, ethane, propane, and acetylene with hydrogen gas to approximately 1% is used as a raw material gas, and a small amount of a gas such as oxygen, carbon monoxide or carbon dioxide may be mixed into the raw material gas, as required, for adjusting film quality and/or film forming speed.

The above-mentioned raw material gas is used, the rigid substrate 1 is heated to a high temperature of 700°C to 1000°C, a plasma is generated by microwave or high frequency or the like, the raw material gas is decomposed in the plasma to generate active species, and a diamond crystal is grown on the rigid substrate 1, to form the film. In forming the film, the hydrogen atoms dissociated in the plasma selectively etches graphite or amorphous carbon generated on the rigid substrate 1, whereby a high diamond component content is ensured, and the peak intensity ratio of the Raman spectroscopy spectrum of the film can be set to the aforementioned range.

However, since the surface of the carbon film formed as aforementioned is accompanied by etching of graphite and amorphous carbon at the time of forming the film, diamond crystal is liable to grow, and a rough surface with the surface roughness Ra greater than the aforementioned range would result. In view of this, in the present invention, film forming conditions are controlled, for example, film forming time is set short, generation of diamond crystal is restrained, and, further, polishing is conducted, whereby the carbon film 3 having both the peak intensity ratio of the aforementioned Raman spectroscopy spectrum and the surface roughness Ra in the aforementioned ranges can be formed on the rigid substrate 1.

Note that the surface polishing of the carbon film 3 formed by vapor deposition can be performed by a method which itself is known. For example, a mechanical polishing method using co-grinding of the carbon film by use of diamond abrasive grains (grindstone) may be used, or a polishing method utilizing a chemical action may be used. A polishing method in which the mechanical and chemical technique are combined may be used. By these polishing method, the surface roughness Ra of the film can be adjusted to within the aforementioned range.

In the present invention, the machining jig including the aforementioned carbon film 3 is used preferably as a cutting tool such as a cutter, an end mill and a file or as a plastic working die such as a punch and a die; particularly, the machining jig is applied preferably to ironing which is severe machining as a machining die, and, further, its application to wet machining using a coolant is optimum for exhibiting maximally the excellent impact resistance of the carbon film 3.

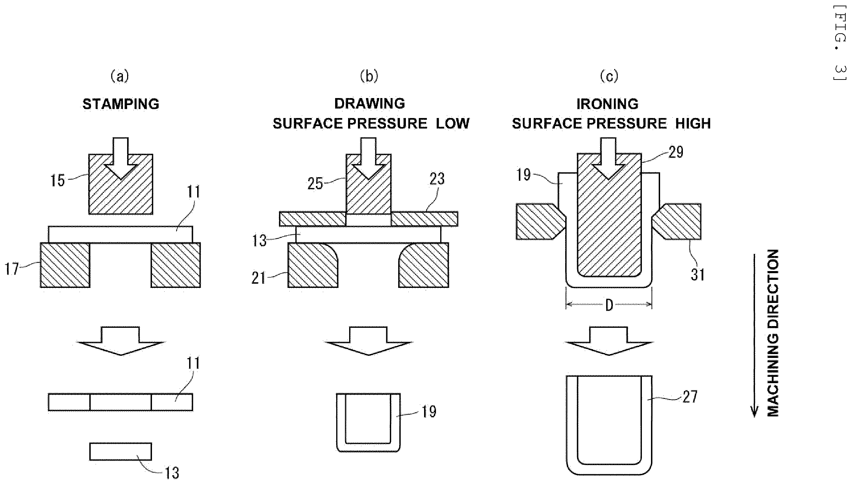

FIG. 3 depicts a method of manufacturing a metallic can by press working in which the machining jig of the present invention is used as a machining die.

In FIG. 3, a blank plate (for example, an aluminum plate) 11 used for forming a metallic can is first subjected to stamping, whereby a disk 13 for the metallic can is obtained (see FIG. 3(a)).

In such stamping, a stamping punch 15 having an outside diameter corresponding to the diameter of the disk 13, and a die 17 holding the blank plate 11 and having an opening corresponding to the diameter of the disk 13 are used. In other words, the blank plate 11 held on the die 17 is stamped by the punch 15, whereby the disk 13 of a predetermined size is obtained.

Note that depending on the form of the formed product manufactured by such a manufacturing process, the blank plate 11 may be stamped in other shape (for example, a rectangular shape).

The disk 13 obtained as above is subjected to drawing, whereby a drawn can (bottomed cylindrical body) 19 having a low height is obtained (see FIG. 3(b)).

In such drawing, the stamped disk 13 is held on a die 21, and the periphery of the disk 13 is held by wrinkle pressing jig 23. The die 21 is formed with an opening, and by pressing the disk 13 into the opening of the die 21 by use of a drawing punch 25, the drawn can 19 is obtained.

Note that a corner part (the side on which the disk 13 is held) at the upper end of the opening of the die 21 is formed with R (curvature part) such that the disk 13 is pressed into the opening of the die 21 swiftly and without snapping, and the outside diameter of the punch 25 is set to be smaller than the diameter of the opening of the die 21 by an amount corresponding substantially to the thickness of the disk 13. In other words, in this drawing, thinning is little conducted. Note that the drawing may be conducted a plurality of times according to the shape of the formed product.

Next, the drawn can 19 obtained as above is subjected to ironing, whereby a metallic can substrate (drawn and ironed can) 27 high in height and thinned is formed (see FIG. 3(c)).

In the ironing, a punch 29 for ironing is inserted into the inside of the drawn can 19 obtained by the drawing, and the punch 29 is lowered while putting the outer surface of the cylindrical body 19 into press contact with the inner surface of an annular ironing die 31, whereby the side wall of the cylindrical body 19 is gradually thinned by the die 31. As a result, a metallic can substrate 27 thinned and having a large height according to the degree of thinning is obtained.

As is understood from FIG. 3, in this series of steps of stamping, drawing and ironing, though sliding property is unnecessary for stamping, sliding property between the die and the workpiece is required from drawing to ironing. Particularly, in ironing, a surface pressure exceeding a yield strength of the workpiece is exerted, so that sliding property is most required.

In the present invention, the machining jig including the aforementioned carbon film 3 is used as the annular ironing die 31.

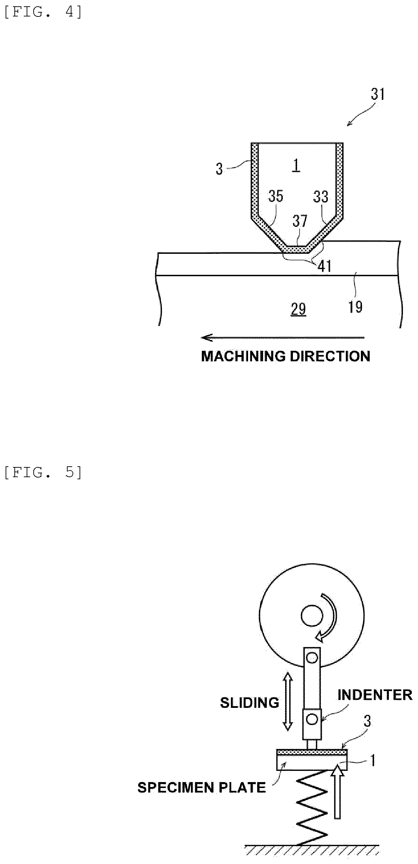

Specifically, referring to FIG. 4 depicting a partial side surface of the die 31 together with FIG. 3 (particularly, FIG. 3(c)), the ironing die 31 has an inclined surface 33 located on the upstream side in the machining direction of the workpiece (tubular body) 19 at the time of ironing, an inclined surface 35 located on the downstream side in the machining direction, and a flat surface 37 therebetween, the region making contact with the workpiece 19 is a machining surface 41, and the aforementioned carbon film 3 is formed on the whole area of these surfaces 33, 35, and 37.

Incidentally, in the ironing die 31 depicted in FIG. 3, it is sufficient that the carbon film 3 is formed on at least the machining surface 41 (namely, the surface on which a surface pressure is exerted at the time of ironing), but it is preferable that both end portions of the carbon film 3 are present at positions spaced from the machining surface 41, from the viewpoint of securely preventing film exfoliation at the time of severe ironing; from such a viewpoint, the carbon film 3 is generally formed on the whole surface (exclusive of the upper surface in FIG. 3) of the rigid substrate 1.

In addition, though not illustrated in the figure, it is preferable that a cooling pipe or the like is passed through the inside of the rigid substrate 1 such as to restrain a temperature rise of the machining surface 41 at the time of ironing.

Further, in the example of FIG. 3, one annular ironing die 31 is disposed; however, a plurality of such annular ironing dies 31 may be disposed at appropriate intervals in the machining direction. In this case, a gap D of the die 31 disposed on the downstream side in the machining direction is small, whereby the workpiece is gradually thinned.

In the present invention, the ironing conducted using the ironing die 31 including the aforementioned carbon film 3 is most preferably what is called wet machining performed under a liquid environment. Specifically, the carbon film 3 is excellent in impact resistance, but the content of diamond crystal is low, and, accordingly, hardness is low, and slidability is poor. Therefore, in the case where the ironing die 31 is applied to dry machining of what is called the non-lubrication system, the critical ironing ratio is small, so that where ironing ratio is enhanced, surface roughening and the like are liable to occur, and, in some cases, defective forming occurs. However, in the wet machining in which ironing is conducted under a liquid environment, a liquid is present between the machining surface 41 (carbon film 3) of the die 31 and the formed surface of the workpiece 19, so that it is possible to enhance the critical ironing ratio and to perform ironing with a high ironing ratio, and the advantage of the present invention in that high impact resistance is secured and machining can be conducted repeatedly without generating film exfoliation can be exhibited maximally.

In such ironing in wet machining, the liquid used is called coolant, and a liquid using water and a mineral oil or an oil and fat (rapeseed oil or the like) as a base oil, adding various additives to the base oil, and dissolving or dispersing it in water is used as the coolant. Particularly, a coolant not containing an oil component may be used, for example, pure water or the like is preferably used from the viewpoint of a cooling action and enhancing lubricity between the machining surface 41 of the die 31 and the machined surface of the workpiece 19. By use of such a coolant, critical ironing ratio can be enhanced. For example, in regard of ironing of an aluminum plate, the critical ironing ratio can be enhanced to 40%.

In addition, in the present invention, the ironing by use of the ironing die 31 including the aforementioned carbon film 3 can be applied to various metals and alloys. For example, aluminum, copper, iron or alloys containing these metals, further surface-treated steel plates such as tin-plated steel plates such as tinplate and aluminum plate having undergone chemical conversion treatment, precoated metal plates having an organic coating on at least one surface thereof and the like can also be subjected to repeated severe ironing with a high ironing ratio.

Particularly, ironing by wet machining by use of a tubular ironing die 31 can be used preferably for ironing at the time of manufacturing e metallic can substrate by the aforementioned process depicted in FIG. 2, and, among others, is most preferably applied to the manufacture of aluminum cans.

<<Method of Manufacturing Seamless Can Bodies>>

The method manufacturing seamless can bodies of the present invention will be described specifically below using the drawings.

<Mold Machining Member>

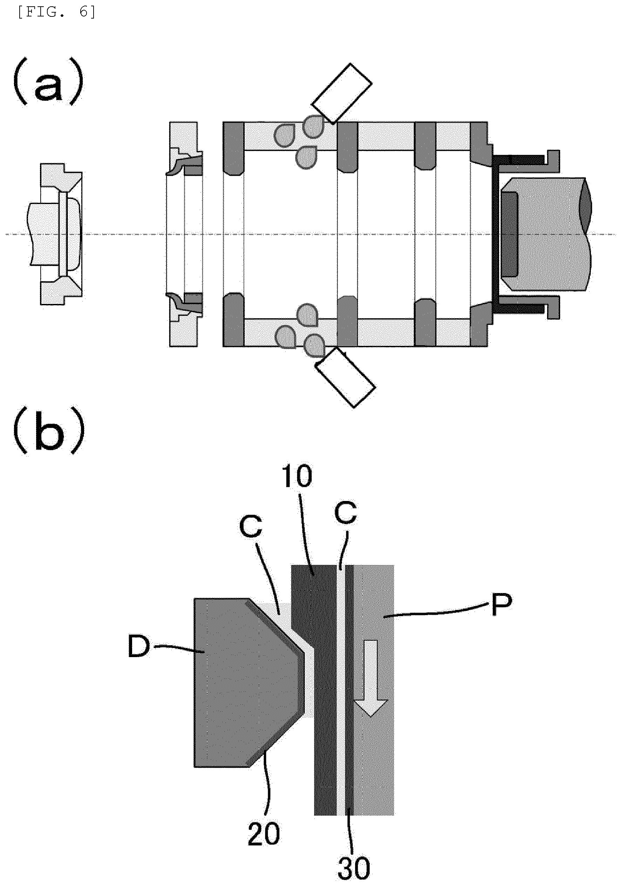

As illustrated in FIG. 6, in the method of manufacturing seamless can bodies in the present embodiment, the method includes press working a metallic material 10 by a machining surface of a mold machining member D by use of the mold machining member formed with a diamond film on the machining surface.

Describing the present embodiment more specifically, as depicted in FIGS. 6(a) and 6(b), an ironing step of the metallic material 10 by the machining surfaces of a die section D and a punch section P, by use of the die section D formed with a diamond film 20 on the machining surface and the ironing punch section P formed with a surface treatment film 30 different from the diamond film on the machining surface, in a state of being mediated with a coolant C.

Here, in the present embodiment, as depicted in FIG. 6, the present invention will be described with particularly ironing, of can manufacture, taken as an example.

However, it is natural that the method of manufacturing seamless can bodies of the present invention is not limited to ironing, but may be applied also to steps of known can manufacture, such as, for example, drawing, doming, necking, and trimming.

In addition, the method is appropriately applicable to known metal press working other than can manufacture, such as, for example, shearing and bending.

The mold machining member in the present embodiment includes the die section D and the punch section P. However, the mold machining member in the present invention is not limited to these, but may be appropriately applied to known mold machining members used for metal press working, for example, a draw pad, a blank punch, a cutter, a blank holder (wrinkle presser), and a plug.

In the present embodiment, the diamond film 20 is formed on the machining surface of the die section D, as depicted in FIG. 6(b). However, the present invention is not limited to this mode, and the diamond film 20 may be formed on the machining surfaces of both the die section D and the punch section P.

In addition, the diamond film 20 may be formed on the machining surface of the punch section P, and a surface treatment film 30 different from the diamond film may be formed on the machining surface of the die section D.

In other words, in the present embodiment, it is sufficient that in the dies at the time of press working, the diamond film 20 is formed on the machining surface of at least one of a male die and a female die.

In the present embodiment, as a method for forming the diamond film 20 on the machining surface of the mold machining member, a known film forming method may be applied. For example, CVD methods such as a heat filament CVD method, a microwave plasma CVD, a highfrequency plasma CVD, and a heat plasma CVD, and known PVD (Physical Vapor Deposition) methods can be applied.

The thickness of the diamond film 20 is preferably 5 to 30 $\mu$m. In the case where the thickness is less than 5 $\mu$m, the diamond film obtained is liable to be cracked and exfoliation is liable to occur, which is unpreferable. On the other hand, in the case where the thickness exceeds 30 $\mu$m, an internal stress in the diamond film is raised and exfoliation is liable to occur, which is unpreferable.

The diamond film preferably has an intensity ratio $I_D/I_G$, where $I_D$ is the maximum peak intensity present at 1333 $\pm$ 10 cm$^{-1}$ in a Raman spectroscopy spectrum analysis, and $I_G$ is the maximum peak intensity present at 1500 $\pm$ 100 cm$^{-1}$, of exceeding 0.6, more preferably equal to or less than 1.1. In the case where the Raman intensity ratio $I_D/I_G$ is equal to or less than 0.6, the content of graphite in the diamond film is high, and the performance intrinsic of diamond cannot be obtained. On the other hand, in the case where the Raman intensity ratio $I_D/I_G$ exceeds 1.1, impact resistance is poor, which is unpreferable.

On the other hand, in the present embodiment, examples of the surface treatment film 30 different from the diamond film and possibly formed on the machining surface of at least one of the male die and the female die of the dies at the time of press working include, for example, carbon films such as a known DLC film, a TiC film, and a TiCN film.

The method for forming these diamond-like carbon films is not particularly limited; for example, known film forming methods such as a CVD method in which a gas is used as a raw material and the gas is decomposed in a chamber to form a film, and a PVD method in which solid carbon is used as a raw material and is evaporated to form a film, can be applied. In addition, for the TiC film, the TiCN film and the like, also, known film forming methods can be applied.

As the thickness of the surface treatment film 30, a thickness in a rational range of a film formed based on the aforementioned known technique can be applied. The thickness of the surface treatment film 30, specifically, is preferably, for example, on the order of 0.1 to 10 $\mu$m.

In other words, the thickness of the surface treatment film 30 in the present embodiment is set to be thinner than the thickness of the diamond film 20.

Note that, in the aforementioned case, the hardness of the surface treatment film 30 is preferably lower than the hardness of the diamond film 20. For example, in the present embodiment, the hardness of the diamond film 20 is preferably a Vickers hardness HV20 of 10000 to 12000, from the viewpoint of durability of the die. On the other hand, the hardness of the surface treatment film 30 is preferably relatively lower than the hardness of the diamond film 20, and is preferably, for example, a Vickers hardness HV30 of 1000 to 8000. This is for the following reasons.

In other words, the diamond film 20 in its property cannot be easily polished, so that it is very difficult to adjust its size, and it is difficult to perform dimensional control between the dies, which may cause an increase in cost.

In recent years, even in ironing of can manufacture, a dimensional control on the order of $\pm$ several $\mu$m is demanded. In such circumstances, when the diamond film 20 is formed on the machining surface of a one-side tool (for example, the die section) in the mold machining member, and the surface treatment film 30 different from the diamond film is formed on the other-side tool (for example, the punch section), as depicted in FIG. 1, the following merits are obtained.

First, at the time of dimensional control, since the surface treatment film 30 is thinner than the diamond film 20, the deviation from a target size is small, and, even in the case where the size is deviated from the target range, polishing of the surface treatment film 30 lower in hardness provides a merit that dimensional control is facilitated.

In addition, in the case where the male die and the female die collide on each other for some reason, the die lower in hardness absorbs the impact, so that there is a merit that damage to the dies can be minimized.

In the present embodiment, that the surface roughness Ra (JIS B-0601-1994) of the diamond film 20 is equal to or less than 0.12 μm is preferable from the viewpoint that it is possible to impart a high sliding characteristic to the dies. Further, in the case where Ra is equal to or less than 0.08 μm, even in severe machining (strong machining) such as ironing, the external appearance of the workpiece (for example, can body) can be made to be a mirror surface or a smooth surface close to a mirror surface, which is more preferable.

In this case, the frictional coefficient μ between the diamond film 20 and the workpiece at the time of ironing is preferably lower than 0.1.

In the present embodiment, as the blank material of the mold machining member formed with the diamond film 20 or the surface treatment film 30, a known material used for dies can be applied.

For example, examples of the applicable material include what is called hard metal obtained by sintering a mixture of tungsten carbide (WC) with a metal binder such as cobalt, cermet obtained by sintering a mixture of a metal carbide such as titanium carbide (TiC) or a titanium compound such as titanium carbonitride (TiCN) with a metal binder such as nickel or cobalt, and hard ceramics such as silicon carbide (SiC), silicon nitride ($Si_3N_4$), alumina ($Al_2O_3$), and zirconia ($ZrO_2$).

<Coolant>

Next, the coolant used in the present embodiment will be described.

As the coolant to be used in the present embodiment, those containing an oil component as a component thereof are preferably mentioned, but a coolant not containing an oil component may be used, and, for example, water such as pure water may be used as the coolant.

In the coolant in the present embodiment, as the oil component, oil components contained in general water-soluble metal processing oil agent compositions may be mentioned. The oil component may be a natural oil component or a synthetic oil component.

Examples of the natural oil component include mineral oils such as paraffin-based ones, naphthene-based ones, and aromatic compound-based ones. In addition, fatty acid glyceride may also be mentioned as a natural oil component.

Examples of the synthetic oil component include hydrocarbon-based ones such as polyolefin, ester-based ones such as fatty acid ester, ether-based ones such as polyalkylene glycol, fluorine-containing ones such as perfluorocarbon, phosphorus-containing ones such as phosphoric acid ester, and silicon-containing ones such as silicic acid ester.

The aforementioned oil components may be used either singly or in combination of two or more kinds of them.

Note that examples of the aforementioned water-soluble metal processing oil agent include water-soluble metal processing oil agents such as A1 kind (emulsion type), A2 kind (soluble type), and A3 kind (solution type) which are defined in JIS K 2241.

In addition, though not defined in JIS Standard, water-soluble metal processing oil agents, what is called synthetic type (a metal processing oil agent not containing a mineral oil but containing a chemically synthesized oil component), may also be mentioned.

In the present embodiment, the concentration of the oil component in the coolant is preferably equal to or less than 4.0 vol%. In this case, in the case of using the coolant containing the oil component in the present embodiment, first, an undiluted solution containing an oil component in a content of equal to or more than 4.0 vol% may be prepared, the undiluted solution may be stored until the time of use, and, at the time of use, the undiluted solution may be diluted with a solvent such as water to prepare a coolant having an oil component concentration of equal to or less than 4.0 vol%.

In other words, it is sufficient that the concentration of the oil component in the coolant is equal to or less than 4.0 vol% in the state of being used.

In addition, as components other than the oil component in the coolant, components contained in general water-soluble metal processing oil agent compositions such as, for example, water, surfactant, anti-rusting agent, extreme pressure additive, coupling agent, non-iron metal anticorrosive agent, preservative, antifoaming agent, chelating agent, pigment, and perfume may be contained, as required.

Thus, in the manufacturing method in the present embodiment, even when the oil component in the coolant is at a comparatively low concentration, defective forming or the like at the time of can manufacture can be restrained, and, as a result, forming stability can be enhanced.

In addition, in the present embodiment, the oil component in the coolant is at a low concentration as compared to the conventional one as aforementioned, so that in a cleaning step for the oil component after can manufacture, cleaning with a chemical agent low in environmental load or water is possible, and the load on the environment can be reduced. In addition, since the waste water treatment after cleaning is facilitated, in the case of recycling and circulating the waste water, recycling rate can be enhanced, and cost and load on environment can be reduced.

<Metallic Material 10 (Workpiece)>

The metallic material as the workpiece in the present embodiment is not particularly limited insofar as it is subjected to press working; for example, not only pure metals such as aluminum, copper, iron, steel, and titanium but also various known metallic materials such as their alloys can be applied as the metallic material. Of these, in the case of forming a can body, aluminum alloys of the aforementioned metallic materials are particularly preferable.

The thickness of the metallic material 10 in the present embodiment is not particularly limited, and an ordinary thickness at the time of can body manufacture can be applied. For example, an example of the thickness of the metallic material 10 in the case of can manufacture by use of an aluminum sheet, in terms of original sheet thickness (thickness of original plate), is 0.1 to 0.5 mm.

<Ironing ratio >

In the method of manufacturing seamless can bodies of the present embodiment, the method preferably including a step of ironing for ironing the metallic material to form a can barrel section such that the ironing ratio (plate thickness reduction rate) is equal to or more than 10%. Note that the method may include a plurality of ironing steps, and the ironing ratio may be changed from step to step. For example, the ironing ratio in the ironing step in the beginning stage may be equal to or more than 10%, and the ironing ratio in the final ironing step may be equal to or more than 30%.

Note that the ironing ratio in the present embodiment is represented by the following formula, where $t0$ is the plate thickness before ironing, and $t1$ is the plate thickness after machining (60 mm part from the can bottom).

$$\texttt{Ironing ratio (\%) = 100} \times \texttt{(t0 - t1)/t0}$$

In other words, according to the method of manufacturing seamless can bodies of the present embodiment, even in severe machining in which the ironing ratio is equal to or more than 30%, defective forming at the time of can manufacture can be restrained, and, as a result, forming stability can be enhanced.

As above, according to the present embodiment, the following effects can be produced.

(A) Since press working such as ironing is conducted in a state of being mediated by the coolant, enhancement of lubricity at the time or ironing makes it possible to enhance critical ironing ratio.

(B) Since press working such as ironing is performed in a state of being mediated by the coolant, such troubles as agglutination or deposition of the workpiece on the dies, variability of material thickness at a can barrel section, and breakage of can barrel can be restrained, and forming stability can be enhanced.

(C) Since press working such as ironing is conducted in a state of being mediated by the coolant by use of the mold machining member (for example, the punch section and the die section) formed with the diamond film on the machining surface, high machining durability of the dies can be realized, and enhancement of lubricity at the time of ironing makes it possible to enhance forming stability of cans.

(D) Since the oil component in the coolant used at the time of press working can be reduced as compared to the conventional technology, in the cleaning step of the oil component after can manufacture, cleaning with a chemical agent low in environmental load or water is possible, and load on environment can be reduced.

In addition, the amount of the coolant used can be reduced, and the amount of a waste liquid can thereby be reduced, so that cost and load on environment can be reduced.

In addition, by reducing the amount of the waste liquid, the influences of pH, biochemical oxygen demand (BOD), chemical oxygen demand (COD), suspended solids (SS), normal hexane, fluorine and the like, which are factors in the treatment of the waste liquid, can be reduced.

(E) In addition, since the waste water treatment after cleaning is facilitated, in the case of recycling and circulating the waste water, recycling rate can be enhanced, and cost and load on environment can be reduced.

EXAMPLES

The machining jig and the machining method of the present invention will be described by way of the following experiment examples. However, the present invention is not limited in any way to the following Examples.

Note that, in the following experiment examples, measurement of surface roughness, calculation of peak intensity in Raman spectroscopy spectrum and impact resistance test were carried out by the following methods.

Surface Roughness:

An arithmetic average roughness Ra was measured using a surface roughness gauge (SURFCOM 2000 SD3) made by Tokyo Seimitsu Co., Ltd. and according to JIS-B-0601.

Peak Intensity in Raman Spectroscopy Spectrum:

Raman spectroscopy spectrum was measured using Raman spectroscope (DXR Raman Microscope) made by Thermo Fisher Scientific Inc. In this instance, an example of Raman Spectroscopy spectrum is depicted in FIG. 2. It is seen that an acute peak $I_D$ in the vicinity of 1333 cm$^{-1}$ and a moderate peak $I_G$ in the vicinity of 1500 cm$^{-1}$ are detected. The curve of the Raman spectroscopy spectrum obtained was approximated by quadratic polynomial, which was made to be a base line, the Raman spectroscopy spectrum was corrected, and the highest peak intensity of peaks present in an optional section was acquired.

Impact Resistance Test:

An impact resistance test was carried out using a tester depicted in FIG. 5.
Specifically, a specimen plate including a carbon film on the surface of a rigid substrate was held by a spring, a load was exerted, a hard ball made of hard metal was attached to the tip of an indenter attached to a rotating plate, the indenter was slid by rotating the rotating plate, thereby striking the hard ball repeatedly, the number of shots until generation of film exfoliation was measured, and impact resistance was evaluated by the number of shots.

Hard ball: 1/2 inch diameter, made of hard metal
Load: 200 N (Hertzian contact stress 5 GPa)
Sliding speed: 400 shots/min.

The evaluation criteria are as follows.

AAA: The number of shots until film exfoliation is equal to or more than 400000.
BBB: The number of shots until film exfoliation is equal to or more than 200000 and less than 400000.
CCC: The number of shots until film exfoliation is equal to or more than 100000 and less than 200000.
DDD: The number of shots until film exfoliation is less than 100000.

<Experiment Example 1>

A carbon film indicating a Raman spectroscopy spectrum with an $I_D/I_G$ intensity ratio set forth in Table 1 was formed on a hard metal substrate, an impact resistance test was conducted, and the impact resistance (film exfoliation) was evaluated. The results are set forth in Table 1.

[Table 1]

| ID/IG | 0.6 | 0.9 | 1.1 | 2.7 |
|---|---|---|---|---|
| Impact resistance | DDD | AAA | CCC | CCC |
| Remarks | DLC | | | |

<Experiment Example 2>

An ironing forming test of an aluminum plate was conducted using a die formed on the surface thereof with a carbon film indicating a Raman spectroscopy spectrum with an $I_D/I_G$ intensity ratio set forth in Table 2. Note that polishing was conducted such that the arithmetic average roughness Ra of the carbon film surface was 0.12 μm.
Note that the aluminum plate was obtained by rolling an A3104 material to a plate thickness of 0.29 mm, stamping the rolled material, a punch of an outside diameter φ66 mm was moved at a speed of 200 spm, first drawing was conducted, to form a tubular body (cup) of φ66 mm, the outer surface of the cup was degreased, and the cup was served to an ironing forming test.
The forming test was conducted at an ironing ratio set forth in Table 2, and ironing was performed by wet forming by use of water as a lubricant or dry forming not using a lubricant.
The results of formability at each ironing step were set forth in Table 2.

[Table 2]

| Experiment No. | $I_D/I_G$ | Lubricant | Ironing rate | Formability | Remarks |
|---|---|---|---|---|---|
| 2-1 | 0.6 | Water | 40% | Formable | DLC |
| | | Water | 45% | Non-formable | DLC |
| | | Dry | 20% | Non-formable | DLC |
| 2-2 | 0 . 9 | Water | 50% | Formable | |
| | | Water | 53% | Non-formable | |
| 2-3 | 1.1 | Water | 50% | Formable | |
| | | Water | 53% | Non-formable | |
| 2-4 | 1.8 | Water | 51% | Formable | |
| | | Water | 52% | Non-formable | |

The surface carbon film ($I_D/I_G$ = 0.9) of the ironing die used in the above experiment No. 2-2 was further polished, to arithmetic average roughness Ra of 0.10 $\mu$m, 0.08 $\mu$m, and 0.05 $\mu$m. Using this ironing die, and using water as a lubricant, ironing was conducted at an ironing ratio of 50%, and the formed body surface was observed. When the arithmetic average roughness Ra was 0.12 $\mu$m and 0.10 $\mu$m, slight scratches were observed on the surface, whereas when the arithmetic average roughness Ra was 0.08 $\mu$m and 0.05 $\mu$m, scratches were not observed and a mirror surface was obtained. Note that, when the arithmetic average roughness was 0.14 $\mu$m and 0.20 $\mu$m which were larger than 0.12 $\mu$m, the specimen was non-formable.

Next, the method of manufacturing seamless can bodies of the present invention will be described by way of the following experiment examples. However, the present invention is not limited in any way to the following examples.

(Example 1)

By the following method, a drawn-ironed can (DI can) having an internal volume of 350 mL was manufactured.

First, an aluminum alloy plate (JIS H 4000 3104 material, 0.28 mm) was prepared. Next, a predetermined amount of a known cupping oil was applied to both surfaces of the aluminum alloy plate as a cupping oil at the time of drawing.

Next, the aluminum alloy plate was stamped into a disk shape with a diameter of 160 mm by a drawing machine, and immediately, drawing was conducted to obtain a cup body having a diameter of 90 mm.

The thus obtained cup body was conveyed to a body maker (can body manufacturing machine), and re-drawing was conducted to obtain a shape with a diameter of 66 mm, after which ironing was performed to obtain a shape with a diameter of 66 mm and a height of 130 mm.

As the die in this instance, one formed on the surface thereof with a diamond film of an average thickness of approximately 10 $\mu$m was used. The surface roughness Ra of the diamond film was set to Ra = 0.08 $\mu$m. In addition, as the surface diamond film of the ironing die, one indicating a Raman spectroscopy spectrum with $I_D/I_G$ intensity ratio of $I_D/I_G$ = 1.1 was used.

As the punch to be used, one formed on the surface thereof with a diamond-like carbon film of a thickness of 0.5 $\mu$m was used.

The ironing ratios at the time of ironing were set as set forth in Table 1. In the coolant used during ironing, a synthetic ester was used as an oil component. The content of the oil component in the coolant was set as set forth in Table 3. Known surfactant, anti-rusting agent, extreme pressure additive, and preservative were added to the coolant.

(Example 2)

A DI can with an internal volume of 350 mL was manufactured in the same manner as in Example 1, except that the content of the oil component in the coolant used during ironing was changed.

(Example 3)

A DI can with an internal volume of 350 mL was manufactured in the same manner as in Example 1, except that the ironing ratio at the time of ironing was changed.

(Example 4)

A DI can with an internal volume of 350 mL was manufactured in the same manner as in Example 1, except that the value of the surface roughness Ra of the diamond film of the ironing die used for ironing was set to Ra = 0.12 µm.

(Comparative Example 1)

A DI can with an internal volume of 350 mL was manufactured in the same manner as in Example 1, except that the content of the oil component in the coolant used at the time of ironing was changed.

(Comparative Example 2)

A DI can with an internal volume of 350 mL was manufactured in the same manner as in Example 1, except that a coolant is not used at the time of ironing but dry press working was conducted.

(Comparative Example 3)

A DI can with an internal volume of 350 mL was manufactured in the same manner as in Comparative Example 2, except that the ironing ratio was changed.

(Comparative Example 4)

A DI can with an internal volume of 350 mL was manufactured in the same manner as in Example 1, except that the value of the surface roughness Ra of the diamond film of the ironing die used for ironing was set to Ra = 0.20 µm.

[Evaluation]

The DI cans obtained by the above methods were evaluated by the following method. The results are set forth in Table 3.

[Ironability]

Three items of (i) the presence or absence of breakage upon ironing, (ii) bleed-through (black streak) at opening of the DI can obtained, and (iii) scratches on an outer surface of a can barrel section, were observed by visual inspection. The DI can having no problem in any of the three items and having can surface as a mirror surface was rated AAA, the DI can having no problem in any of the three items and being excellent was rated BBB, the DI can having a problem in any of the three items but being endurable to practical use was rated CCC, and the DI can having a problem in any of the three items and being not endurable to practical use was rated DDD.

[Cleaning Property]

The DI can obtained was subjected to spray cleaning using a cleaning liquid, was washed with water, after which the presence or absence of water repelling on the DI can surface was determined by visual observation. Note that, in the case where water repelling is generated, it is said that the oil component of the coolant is left on the DI can surface, which influences the later step. Therefore, the DI can on which the water repelling was not generated was evaluated as BBB, and the DI can on which the water repelling was generated was evaluated as DDD. In addition, as the cleaning liquid, a sulfuric acid-based degreasing agent generally used in a degreasing step for DI cans was used. In addition, the temperature of degreasing was 50°C which is lower than the conventional 70°C.

[Waste Water Treatability]

The DI can was subjected to spray cleaning by use of the cleaning liquid, was washed with water, after which the waste water was accommodated in a beaker, and COD was measured by a known method. When the COD was less than 200 ppm, the DI can was determined as BBB (waste water treatability is good), and when the COD was equal to or more than 200 ppm, the DI can was determined as DDD (waste water treatability is poor). The results are set forth in Table 3.

[Table 3]

|  | Oil content (vol%) | Ironing rate (%) | Diamond membrane Ra ($\mu$m) | Ironability | Cleanability | Waste water treatability |
|---|---|---|---|---|---|---|
| Example 1 | 4.0 | 40 | 0.08 | AAA | BBB | BBB |
| Example 2 | 0.50 | 40 | 0.08 | AAA | BBB | BBB |
| Example 3 | 4.0 | 45 | 0.08 | AAA | BBB | BBB |
| Example 4 | 4.0 | 40 | 0.12 | BBB | BBB | BBB |
| Comp.Ex. 1 | 5.0 | 40 | 0.08 | AAA | DDD | DDD |
| Comp.Ex. 2 | dry | 40 | 0.08 | CCC | BBB | BBB |
| Comp.Ex. 3 | dry | 45 | 0.08 | DDD | BBB | BBB |
| Comp.Ex. 4 | 4.0 | 40 | 0.20 | DDD | BBB | BBB |

According to the method of manufacturing seamless can bodies of the present invention, it is clear that the DI cans obtained have all of the ironability, cleaning property, and waste water treatability.

[Industrial Applicability]

The present invention can be preferably utilized in the field of metal press working in which consideration of environment is made while maintaining machinability and forming stability.

[Reference Signs List]

1:     Rigid substrate
3:     Carbon film
19:    Workpiece (Tubular body)
31:    Ironing die
41:    Machining surface
D:     Die section
P:     Punch section
C:     Coolant
10:    Metallic material
20:    Diamond film
30:    Surface treatment film

**Claims**

1. A machining jig having a carbon film formed on a machining surface of a rigid substrate,
   wherein the carbon film indicates a Raman spectroscopy spectrum with an intensity ratio exceeding 0.6, as expressed by the following formula

$$I_D / I_G$$

   where

$I_D$ is a maximum peak intensity at 1333 ± 10 cm$^{-1}$ in the Raman spectroscopy spectrum of a surface of the carbon film, and
$I_G$ is a maximum peak intensity at 1500 ± 100 cm$^{-1}$ in the Raman spectroscopy spectrum of the surface of the carbon film.

2. The machining jig according to claim 1, wherein the surface of the carbon film is a smooth surface having an arithmetic average roughness Ra of equal to or less than 0.12 μm.

3. The machining jig according to claim 1 or 2, wherein the carbon film indicates a Raman spectroscopy spectrum with the intensity ratio in a range of equal to or less than 1.1.

4. A machining method comprising:
machining a workpiece in a liquid environment by use of the machining jig according to any one of claims 1 to 3.

5. The machining method according to claim 4, wherein the machining jig is an ironing die, and the machining is ironing.

6. A method of manufacturing seamless can bodies, comprising the step of:
press working a metallic material at a machining surface of a mold machining member in a state in which a coolant is interposed by use of the mold machining member formed with a diamond film on the machining surface.

7. The method of manufacturing seamless can bodies according to claim 6, wherein an oil component contained in the coolant is equal to or less than 4 vol%.

8. The method of manufacturing seamless can bodies according to claim 6 or 7, wherein the mold machining member includes at least a die section.

9. The method of manufacturing seamless can bodies according to any one of claims 6 to 8,

wherein the press working includes ironing of the metallic material, and
a can barrel section is formed by ironing the metallic material such that an ironing ratio in the ironing is equal to or more than 10%.

10. The method of manufacturing seamless can bodies according to any one of claims 6 to 9, wherein a surface roughness Ra of the mold machining member used for the ironing is equal to or less than 0.12 μm.

11. The method of manufacturing seamless can bodies according to any one of claims 6 to 9, wherein a surface roughness Ra of the mold machining member used for the ironing is equal to or less than 0.08 μm.

[FIG. 1]

[FIG. 2]

[FIG. 3]

MACHINING DIRECTION

(a) STAMPING

(b) DRAWING
SURFACE PRESSURE LOW

(c) IRONING
SURFACE PRESSURE HIGH

[FIG. 4]

MACHINING DIRECTION

[FIG. 5]

SLIDING

INDENTER

SPECIMEN PLATE

[FIG. 6]

(a)

(b)

## INTERNATIONAL SEARCH REPORT

| International application No. |
| --- |
| PCT/JP2019/040934 |

**A. CLASSIFICATION OF SUBJECT MATTER**
Int.Cl.  B21D22/28(2006.01)i, B21D37/01(2006.01)i, B21D37/18(2006.01)i,
B21D51/26(2006.01)i

According to International Patent Classification (IPC) or to both national classification and IPC

**B. FIELDS SEARCHED**

Minimum documentation searched (classification system followed by classification symbols)
Int.Cl. B21D22/28, B21D37/01, B21D37/18, B21D51/26

| Documentation searched other than minimum documentation to the extent that such documents are included in the fields searched | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 10-137861 A (SKY ALUM CO., LTD.) 26 May 1998, paragraphs [0001], [0010], [0019]-[0021], [0023], [0026], [0036], [0039], fig. 3 (Family: none) | 6-8, 10-11 |
| Y | | 1-5, 9 |

☒ Further documents are listed in the continuation of Box C.  ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 13 December 2019 (13.12.2019) | 24 December 2019 (24.12.2019) |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2019/040934

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2017/033791 A1 (TOYO SEIKAN GROUP HOLDINGS, LTD.) 02 March 2017, paragraphs [0016], [0025]-[0029], [0049] & US 2018/0229287 A1, paragraphs [0021], [0043]-[0052], [0083] & EP 3342501 A1 & CN 107921518 A & KR 10-2018-0035897 A & BR 112018003601 A2 & TW 201718240 A | 1-5, 9 |
| A | JP 5-169162 A (KYOCERA CORP.) 09 July 1993, paragraph [0013] (Family: none) | 1-11 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI5169162 A
- JP HEI6297207 A
- JP HEI890092 A
- JP 6012804 B

- JP HEI10137861 A
- JP HEI11277160 A
- JP 2013163187 A
- WO 2017033791 A